# EUROPÄISCHE PATENTSCHRIFT

(11) **EP 2 421 707 B1**
(45) Veröffentlichungstag und Bekanntmachung des Hinweises auf die Patenterteilung: **31.05.2017**
(21) Anmeldenummer: 10715521.0
(22) Anmeldetag: 08.04.2010
(51) Int. Cl.: B32B 27/00, H01L 51/52, H01M 2/08

(54) **TRANSPARENTE BARRIERELAMINATE**
TRANSPARENT BARRIER LAMINATES
FILMS BARRIÈRES STRATIFIÉS TRANSPARENTS

(30) Priorität: 24.04.2009 DE 102009018518
(43) Veröffentlichungstag der Anmeldung: 29.02.2012
(73) Patentinhaber: tesa SE, 22848 Norderstedt (DE)
(72) Erfinder: KEITE-TELGENBÜSCHER, Klaus, 22529 Hamburg (DE); GRÜNAUER, Judith, 22761 Hamburg (DE); ELLINGER, Jan, 20257 Hamburg (DE)
(86) Internationale Anmeldenummer: PCT/EP2010/054628
(87) Internationale Veröffentlichungsnummer: WO 2010/121905

(56) Entgegenhaltungen:
- EP-A1- 1 466 725
- WO-A2-03/028903

## Beschreibung

Die vorliegende Erfindung betrifft transparente Permeationsbarrierefolien.

Derartige transparente Permeationsbarrierefolien finden Anwendung in der anorganischen und/oder organischen (Opto-)Elektronik als Schutz für die insbesondere Wasserdampf- und Sauerstoff-empfindlichen elektronischen Anordnungen.

Solche elektronische Anordnungen, insbesondere optoelektronische Anordnungen, werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren, wie Hochdruck, Tiefdruck, Siebdruck, Flachdruck oder auch so genanntes "non impact printing", wie etwa Thermotransferdruck, Tintenstrahldruck oder Digitaldruck. Vielfach werden aber auch Vakuumverfahren, wie z.B. chemische Gasphasenabscheidung (Chemical Vapor Deposition - CVD), physikalische Gasphasenabscheidung (Physical Vapor Deposition - PVD), plasmaunterstützte chemische oder physikalische Gasphasenabscheidung (plasma enhanced chemical or physical vapour deposition - PECVD), Sputtern, (Plasma-)Ätzen oder Bedampfung, verwendet, wobei die Strukturierung in der Regel durch Masken erfolgt.

Als Beispiele für bereits kommerziell genutzte oder in ihrem Marktpotential interessante elektronische, insbesondere optoelektronische, Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LLEDs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen , organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Von besonderer Bedeutung für die Realisierung einer ausreichenden Lebensdauer und Funktion von (opto-)elektronischen Anordnungen im Bereich der anorganischen und/oder organischen (Opto-)Elektronik, ganz besonders im Bereich der organischen (Opto-) Elektronik, ist ein Schutz der darin enthaltenen Komponenten vor Permeanten zu sehen. Permeanten können eine Vielzahl von niedermolekularen organischen oder anorganischen Verbindungen sein, relevant sind insbesondere Wasserdampf und Sauerstoff.

Eine Vielzahl von (opto-)elektronischen Anordnungen im Bereich der anorganischen und/ oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung der Anordnung erforderlich, da andernfalls die Leistung über den Anwendungszeitraum nachlässt. So kann sich beispielsweise durch eine Oxidation der Bestandteile bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere in der organischen (Opto-)Elektronik, gibt es daher einen besonderen Bedarf für flexible Substrate, die die elektronischen Komponenten schützen und eine Permeationsbarriere für Permeanten, wie Sauerstoff und/oder Wasserdampf, darstellen. Ein Maß für die Güte des Schutzes bzw. der Kapselung stellen die Sauerstofftransmissionsrate (Oxygen Transmission Rate - OTR) und die Wasserdampftransmissionsrate (Water Vapor Transmission Rate - WVTR) dar. Die jeweilige Rate gibt dabei den Fluss von Sauerstoff bzw. Wasserdampf durch einen Film unter spezifischen Bedingungen von Temperatur und relativer Luftfeuchtigkeit sowie Partialdruck an. Je geringer diese Werte sind, desto besser ist das jeweilige Material zur Kapselung geeignet. Die Anforderungen bezüglich der Permeationsbarriere gehen deutlich über diejenigen im Verpackungsbereich hinaus. Erforderlich sind eine WVTR < 10⁻³ g/(m²d) und eine OTR < 10⁻³ cm³/(m² d bar).

Darüber hinaus ist es in vielen Fällen, z.B. bei Solarzellen oder Außendisplays, notwendig, dass das Material der Barrierefolie zumindest auf einer Seite der elektronischen Zelle langzeitig, auch unter UV- und Witterungsbelastung, optisch hochtransparent ist.

Aus dem Verpackungsbereich bekannte polymere Mehrschicht-Laminate oder Koextrusionsfolien erreichen die geforderten Werte bei vorgegebener Schichtdicke nicht. Die Schichtdicke ist insofern begrenzt, als z.B. die Flexibilität des Laminats mit zunehmender Schichtdicke abnimmt und flexible Laminate somit nur eine bestimmte Schichtdicke aufweisen dürfen. Auch mit organischen oder anorganischen Beschichtungen oder Schichten kombinierte Verpackungsfolien sind Stand der Technik. Eine solche Beschichtung kann durch übliche Verfahren, wie z.B. Lackieren, Drucken, Bedampfen, Sputtern, Co-Extrusion oder Lamination erfolgen. Beispielhaft, aber nicht einschränkend als Beschichtungsmaterialien erwähnt seien hier Metalle, Metalloxide, wie z.B. Oxide oder Nitride des Siliziums und des Aluminiums oder Indium-Zinn-Oxid (ITO), oder metallorganische Verbindungen, wie sie etwa bei Sol-Gel-Beschichtungen Einsatz finden. Ein Beispiel für solche Lösungsansätze ist in EP1785269A1 und DE19623751A1 offenbart.

Der Stand der Technik im Verpackungsfolienbereich, insbesondere im Hinblick auf dünne Folien ist im Schlussbericht des BMBF-Projekts "Verbundvorhaben: Umweltentlastung in der Produktion und Nutzung von Verpackungen aus Verbundfolien durch Halbierung des Materialeinsatzes" (01.03.2003 bis 31.05.2006) umfassend dargestellt. Weitere Informationen zum Stand der Technik finden sich in "Barrier Polymers" (Encyclopedia of Polymer Science and Technology, John Wiley & Sons, 3. Auflage, Vol. 5, S. 198 bis 263).

Solche Verpackungsfolien erreichen die oben genannten Anforderungen nicht, selbst wenn sie, wie ebenfalls bekannt, als Laminat zweier derart beschichteter Folien zur Verfügung gestellt werden. Das Hinzunehmen weiterer Laminierschritte ist bei der derzeit in der Regel verwendeten Foliendicke von etwa 12 µm bei Polyesterfolie (PET) unvorteilhaft, da sich der Materialverbrauch erhöht und damit Verpackungen teuerer werden. Auch die Abgaben für die Entsorgung erhöhen sich. Darüber hinaus verringert sich die Flexibilität unvorteilhaft. Unerwünschter Weise zeigen die bisher verfügbaren Doppellaminate des weiteren eine verringerte Transparenz und eine vergrößerte Lichtstreuung (Haze), was auf im Laminierkleber eingelagerte Blasen zurückgeht.

Für die Anwendung in flexiblen (opto)elektronischen Aufbauten werden aus dem Verpackungsbereich bekannte Folien verschiedenen Modifikationen unterzogen. Zu diesen gehören z.B. ein Überzug mit wasserabweisenden Schichten (US 7306852 B2, JP2003238911A), die Verwendung spezieller Laminierkleber (WO2003040250 A1, WO2004094549A1, DE10138423 A1, WO2006/015659 A2), glasartige Beschichtungen (US5925428A), das Einbetten von Schichtsilikaten oder anderen Nanomaterialien in die Polymerfolie oder Beschichtungen solcher Art (WO2007130417 A2, WO2004024989 A2), die Verwendung von Polymerfolien mit sehr hoher Glasübergangstemperatur, die Wärmebehandlung metalloxidbeschichteter Folien (US 7192625A) sowie die Verwendung von die Permeanten ad- oder absorbierenden Materialien (Getter, Scavanger) in der Folie oder als Beschichtung (WO2006/036393 A2).

Eine technische Lösung ist bisher die Verwendung von Dünnglas (ca. 30 - 50 µm Dicke). Das Glas ist allerdings nur sehr schwer handhabbar, nur mit speziellen Verfahren zu konfektionieren, und die Gefahr der Zerstörung der Glasfläche ist hoch. Daher wird das Dünnglas oft mit einer Polymerfolie kaschiert oder mit einem Polymer beschichtet. Der Stand der Technik ist ausführlich in der WO2000041978 erläutert. Das dort beschriebene Verfahren ist dadurch gekennzeichnet, dass eine Vielzahl von Fertigungsschritten benötigt wird, um einen flächigen Glas-Polymer-Verbund herzustellen. Anbieter solcher Dünngläser sind z.B. die Fa. Schott, Mainz und Corning, USA.

Die Anforderungen hinsichtlich der Barriereeigenschaften erreichen auch Mehrschichtaufbauten von anorganischen und organischen Schichten auf einer Trägerfolie (oft mehr als 10 Schichten). Dabei werden die anorganischen Schichten in der Regel im Vakuum abgeschieden. Beispiele aus dem Stand der Technik sind in den WO 00/36665 A1, WO01/81649 A1, WO 2004/089620 A2, WO 03/094256 A2 und WO2008/057045 A1 beschrieben. Als organische Schichten werden oft Lacke auf Acrylatbasis eingesetzt. Kommerziell angewendet wird diese Technologie derzeit von der Fa. Vitex Systems, San Jose, USA sowie vom Forschungsinstitut IRME, Singapur. Alle genannten Systeme erfordern eine Substratbasis, die eine Größe von mindestens 10 µm, eher deutlich darüber, aufweist.

Neben anorganischen und organischen Schichten werden auch Hybridmaterialien wie organisch modifizierte Keramiken als mehrfache Lagen in der Schichtfolge eingesetzt. Dabei kommt die Sol-Gel-Technologie zum Einsatz. Diese Materialien werden derzeit am Fraunhofer-Institut für Verfahrenstechnik und Verpackung (IVV) in Zusammenarbeit mit dem Fraunhofer-Institut für Silicatforschung (ISC) entwickelt (s. DE19650286 und Vasko K.: Schichtsysteme für Verpackungsfolien mit hohen Barriereeigenschaften, Dissertation an der TU München, 2006).

Die bisherigen technischen Lösungen für eine flexible Permeationsbarriere sind in ihrer Barrierewirkung nicht ausreichend oder in ihrem Aufbau sehr komplex und erfordern oft große Investitionen in Anlagentechnik (insbesondere für die Vakuumverfahren). Dies steht der angestrebten kostengünstigen Lösung im Wege.

Es ist daher Aufgabe der vorliegenden Erfindung, eine Barrierefolie mit hoher Transparenz, geringer Dicke und damit hoher Flexibilität sowie mit für die Verkapselung von (opto)-elektronischen Bauelementen ausreichender Barrierewirkung, insbesondere gegen Wasserdampf und Sauerstoff, sowie ein Verfahren zu ihrer Herstellung bereitzustellen.

Diese Aufgabe wird gelöst durch eine transparente substratbasisfreie Permeationsbarrierefolie, bestehend aus
einer ersten Polymerschicht,
einer ersten anorganischen Barriereschicht,
zumindest einer zumindest teilweise organischen Ausgleichsschicht,
zumindest einer weiteren anorganischen Barriereschicht sowie aus
zumindest einer weiteren Polymerschicht,
wobei sowohl die Polymerschichten wie auch die anorganischen Barriereschichten jeweils aus dem selben oder aus unterschiedlichem Material bestehen können und die anorganischen Barriereschichten eine Dicke zwischen 2 und 1000 nm, vorzugsweise zwischen 10 und 500 nm, besonders bevorzugt zwischen 20 und 100 nm, aufweisen und die Polymerschichten sowie die zumindest teilweise organische Ausgleichsschicht eine Dicke von weniger als 5 µm, vorzugsweise zwischen 0,5 und 4 µm, aufweisen.

Vorteil dieser erfindungsgemäßen Permeationsbarriere- oder Barriereverbundfolie ist, dass kein dickes, die Flexibilität herabsetzendes Substrat verwendet wird. Solche Substrate sind im Stand der Technik in der Regel mindestens 10 µm dick, weshalb die auf einer solchen Basis hergestellten Systeme für eine Anwendung, die Flexibilität erfordert, wenn überhaupt nur sehr eingeschränkt in Betracht kommen. Überraschend ist es demgegenüber vorliegend gelungen, anorganische Barriereschichten auch auf sehr dünnen Polymerschichten ohne thermische oder mechanische Schädigung abzuscheiden, so dass insgesamt Folien von geringer Dicke hergestellt werden und als flexibler Schutz für elektronische Anwendungen zur Verfügung gestellt werden können.

Substratbasisfrei im Sinne der Erfindung bedeutet dabei, dass kein Substrat oder Träger mit einer Dicke von mehr als 10 µm, insbesondere kein Substrat oder Träger mit einer Dicke von mehr als 5 µm, permanenter Bestandteil der Folie ist, sondern die Folie insbesondere bei der Anwendung ohne Substratbasis verwendet wird.

Polymerschichten, insbesondere thermoplastische Polymerschichten, können orientiert bzw. streckorientiert werden, um ihnen verbesserte mechanische Eigenschaften zu verleihen. Insbesondere werden sie biaxial orientiert, wobei die Molekülketten des Polymeren durch Strecken in zwei Vorzugsrichtungen ausgerichtet werden. Der Orientierungszustand einer Polymerschicht bzw. einer Folie wird gemessen über die Orientierungsdoppelbrechung (Δn) der biaxial orientierten Folie bzw. Schicht: Δn = n _{MD}- n _{TD}, wobei n _{MD} der Lichtbrechungsindex in Maschinenrichtung, also längs, und n _{TD} der Lichtbrechungsindex in transverser Richtung, also quer, ist. Ist die Streckung in den beiden in der Regel senkrecht zueinander verlaufenden Streckrichtungen, also biaxial, ungefähr mit dem gleichen Faktor (Grad) erfolgt, spricht man von "isotropen" oder "balanced" Folien, und für n _{MD} und n _{TD} werden nahezu gleiche Werte gemessen. Die Differenz Δn beträgt dann etwa Null, wobei jeweils n_{MD} und n_{TD} eine Differenz zum Brechungsindex im unverstreckten Zustand aufweisen. Anisotrope Folien weisen in einer Vorzugsrichtung besonders hohe mechanische Eigenschaften auf. Solche Folien werden in einer Richtung (monoaxial) in besonders hohem Maß gestreckt und zeigen dann auch in dieser einen Richtung einen deutlich höheren Lichtbrechungsindex im Vergleich zu der dazu senkrechten anderen Richtung. Die Differenz Δn nimmt dann konkrete Werte an. Stand der Technik hierzu ist in der EP 0 193 844 wiedergegeben.

In einer bevorzugten Ausführung liegen die Polymerschichten in ihrer Flächenausdehnung in zumindest einer Richtung (monoaxial) orientiert vor, besonders bevorzugt ist eine orientierte Ausrichtung in zwei Richtungen (biaxial). Diese Polymerschichten bestehen aus Folien, insbesondere aus monoaxial oder biaxial verstreckten Folien. Durch solch eine Orientierung der Polymermoleküle wird die mechanische Stabilität der Polymerschicht sowie deren Permeationsbarriere erhöht.

Als Polymere können alle dem Fachmann bekannten transparenten Polymere verwendet werden, die zur Folienherstellung geeignet sind, z.B. Polyolefine und deren Copolymere, Poly(meth)acrylate, Polyester, Polystyrol, Polyvinylbutyral, bevorzugt werden aber Folien mit einem hohen Elastizitätsmodul (E-Modul) eingesetzt, wie z.B. Polyethylenterephthalat (PET), Polyethylennaphthalat (PEN), Polybutylenterephthalat (PBT), Fluorpolyester, Polymethylpenten (PMP), Polynorbornen, substituierte Polyarylate, insbesondere solche der Firma Ferrania, wie sie in Simone Angiolini, Mauro Avidano: "P-27: Polyarylate Films for Optical Applications with Improved UV-Resistance" (SID 01 DIGEST, S. 651-653) beschrieben sind, Polyimide (PI), Cyclo-Olefin-Copolymere (COC), Polysulfone (PSU), Polyphenylsulfon (PPSU), Polyethersulfon (PESU) oder Polycarbonat (PC). Dies gilt auch für Copolymere auf Basis der vorgenannten Polymeren, wobei "auf Basis" zu verstehen ist als Anteil von mehr als 50 Mol-%. Dabei sind Polymere bzw. Copolymere mit einem E-Modul von mehr als 2.000 MPa, bevorzugt von mehr als 3.000 MPa gemessen bei Raumtemperatur nach DIN EN ISO 527 (Probekörper Typ 2, 23°C, 50% relative Luftfeuchtigkeit, Abzugsgeschwindigkeit 1 mm/min besonders geeignet. Ein hoher Elastitzitätsmodul ist von Vorteil, da die erfindungsgemäß eingesetzten Polymere als sehr dünne Schichten bzw. Folien eingesetzt werden. Ein hoher Elastizitätsmodul wirkt einem ungewünschten Dehnen der Folie bei der Herstellung entgegen.

In der folgenden Tabelle 1 sind besonders geeignete transparente Polymere mit ihren E-Modulen sowie WVTR und OTR angeführt.

**Tabelle 1**

| Typ | Wasseraufnahme [%] | **E-Modul [MPa]** | WVTR [cm³/(m²d)] | OTR [cm³/(m²d bar)] |
|---|---|---|---|---|
| **PI (25µm)** | 1,8/0,8 | **2500** | 22 | 100 |
| PA6 (40µm) | 8,0 / 1,5 | **1400** | 40 | 25 |
| **PET (50µm)** | 0,5 / 0,2 | **3800** | 5 | 35 |
| PET (23 µm) | 0,5 / 0,2 | **3800** | 9 | 70 |
| BOPP (40µm) | < 0,1 / < 0,1 | **2200** | 0,5 | 500 |
| **COC (100µm)** | < 0,1 / < 0,1 | **2400** | 0,9 | 190 |
| PMMA (50µm) | 2,1 / 0,6 | **1000** | 0,1 | 1100 |
| **PC (125 µm)** | 0,2 | **2400** | 35 | 600 |

Ganz besonders geeignet sind Polymere mit einer Wasseraufnahme von weniger als 0,1 Gew.-%, ermittelt nach DIN EN ISO 62 (Methode 1) bei 23°C nach 24 Stunden, da bei deren Verwendung die Gefahr der Blasenbildung im Verbund oder bei dessen Verwendung, insbesondere in feucht-warmer Umgebung, geringer ist.

Als anorganische Barriereschichten eignen sich besonders gut im Vakuum (z.B. mittels Verdampfen, CVD, PVD, PECVD) oder unter Atmosphärendruck (z.B. mittels Atmosphärenplasma, reaktiver Coronaentladung oder Flammenpyrolyse) abgeschiedene Metalle oder insbesondere Metallverbindungen wie Metalloxide, -nitride oder -hydronitride, z.B. Oxide oder Nitride des Siliziums, des Bors, des Aluminiums, des Zirkoniums, des Hafniums oderdes Tellurs oder Indium-Zinn-Oxid (ITO). Ebenfalls besonders geeignet sind mit weiteren Elementen dotierte Schichten der vorstehend genannten Varianten. Als besonders geeignetes PVD-Verfahren ist High-Power-Impulse-Magnetron-Sputtering zu nennen, durch das sich besonders permeationsdichte Schichten bei geringer Temperaturbelastung der Folie verwirklichen lassen.

Die zumindest teilweise organische Ausgleichsschicht ist ein Laminierkleber. Als solcher eignen sich prinzipiell alle dem Fachmann bekannten transparenten lösemittelhaltigen und lösemittelfreien Laminierkleber, z. B. auf der Basis von ein- und mehrkomponentigen Polyurethanen (z.B. Liofol-Laminierkleber der Fa. Henkel), Acrylaten, Epoxiden, natürlichen oder synthetischen Kautschuken, Silikaten oder Silikonen. Auch Laminierkleber auf der Basis von anorganisch-organischen Hybriden (z.B. Sol-Gel-Technologie), wie z.B. der Laminierkleber Inobond der Fa. Inomat, Bexbach, sind für die erfindungsgemäßen Folien besonders geeignet.

Weiterhin besonders geeignet als Laminierkleber sind auch haft- oder heißschmelzklebrige Systeme, z.B. aus der Schmelze aufgetragene oder mit einer Polymerfolie koextrudierte Polyolefine oder deren Copolymere, wie sie z.B. von der Fa. Clariant unter dem Handelsnamen Licocene angeboten werden.

Bevorzugt werden mittels aktinischer Strahlung, insbesondere UV- oder Elektronenstrahlung, ausgehärtete Systeme eingesetzt, da sich diese durch besonders niedrige Viskositäten auszeichnen und somit ohne die Gefahr der mechanischen Zerstörung auf die sehr dünne Folie aufgetragen werden können. Die Viskosität der Klebeschicht kann in einer weiteren vorteilhaften Variante auch dadurch abgesenkt werden, dass den in der Regel als lösemittelfreie Klebstoffe konzipierten Systemen Lösemittel zur Viskositätsabsenkung zugesetzt werden.

Durch die geringen Viskositäten können diese Klebersysteme bevorzugt mittels nichtkontaktierenden Verfahren aufgebracht werden, z.B. durch Sprühen aus der Aerosolphase oder durch Vorhangbeschichtung. Diese Verfahren sind aufgrund der geringen mechanischen Beanspruchung der dünnen Polymerfolien auch für andere genügend niedrigviskose Klebersysteme bevorzugt.

In einer besonders bevorzugten Ausführung besitzt der Laminierkleber eine Wasserdampfpermeation von nicht mehr als 10 g/m²d und/oder eine Sauerstoffpermeation von nicht mehr als 100 cm³/m² d bar, da dann der Kleber selbst zur Barriere der Gesamtfolie beiträgt.

In die Polymermaterialien oder das organische Material werden bevorzugt weitere permeationshemmende Stoffe als Schicht oder im Bulk eingearbeitet, z.B. den Permeanten absorbierende oder adsorbierende Stoffe (Getter, Scavenger), wie sie dem Fachmann bekannt sind, oder den Permeationsweg verlängernde Stoffe wie z.B. Schichtsilikate.

Weiterhin ist es gelungen, solche Folien mittels eines Laminierklebers blasenfrei zusammenzulaminieren, so dass in einer weiteren bevorzugten erfindungsgemäßen Ausführung der oben beschriebene Aufbau zumindest noch einmal auf sich selbst laminiert wird. Es ist dabei möglich, im Aufbau eine hohe optische Transparenz (Transmission > 80 %, besonders bevorzugt > 85 %; Haze < 10% besonders bevorzugt < 5 %) zu bewahren. Damit ergibt sich ein bevorzugter Aufbau in Form eines speziellen Folienlaminats aus besonders dünnen Barrierefolien.

Dabei können die jeweils für die einzelnen Schichten verwendeten Materialien gleich oder unterschiedlich sein.

Vorteilhaft zum Erreichen einer hohen Transmission ist es, wenn der Unterschied der Brechungsindizes des Polymers, der anorganischen Barriereschicht sowie der zumindest teilweise organischen Ausgleichsschicht nicht mehr als 0,3, insbesondere nicht mehr als 0,1 beträgt. Dies kann z.B. mit der Kombination Polymethymethacrylat-Folie (n=1.49), SiOₓ-Barriereschicht (n=1,5) und Acrylat-Haftkleber (n=1.48) erreicht werden. Ein weiteres Beispiel für einen solchen Aufbau ist die Kombination Polycarbonatfolie (n= 1.585), AlₓO_{y}-Barriereschicht (n=1.63) und Epoxid-Ausgleichsschicht (n=1,6).

Ein Vorteil der Mehrfachlamination des gleichen oder ähnlichen Aufbaus ist die einfache Herstellung von sehr dünnen, hochtransparenten und mit hoher Barriere ausgestatteten Verkapselungsfolien. Dies ist bei Folien des Standes der Technik nicht möglich, da hier im Mehrschichtaufbau selbst bereits recht dicke Substratfolien eingesetzt werden, so dass sich insgesamt eine Dicke ergäbe, die zu groß ist, als dass noch z.B. eine ausreichende Flexibilität gewährleistet wäre.

Die oben beschriebenen Aufbauten werden bevorzugt weiterhin auf zumindest einer Seite ganzflächig oder partiell mit weiteren funktionalen Schichten oder Strukturierungen ausgestattet. Als funktionale Schichten eignen sich z.B. insbesondere elektrisch leitfähige Schichten (z.B. transparente leitfähige Oxide wie ITO), thermisch leitfähige Schichten (z.B. mit bevorzugt nanoskaligem Aluminiumoxid oder Bornitrid angereicherte Schichten), Schutzschichten oder Kleberschichten, wie z.B. Haftkleber oder Heißschmelzkleber. Schutzschichten sind insbesondere für den Transport und die Lagerung von Bedeutung, um die Folie vor Beschädigung zu schützen und z.B. als Kratzschutz zu dienen. Auch bei der Verarbeitung der Folie kann eine Schutzschicht vorteilhaft sein, indem sie die Folie beispielsweise vor mechanischer Beanspruchung schützt. Weitere geeignete funktionelle Schichten sind reflektionsvermindernde Schichten oder lichtaus- oder lichteinkoppelnde Schichten. Letztere kommen insbesondere bei selbstleuchtenden Displays oder Solarzellen zum Einsatz, wo sie die Ausbeute erhöhen. Durch Verwendung lichtauskoppelnder Schichten kann hier die Ausbeute an austretendem Licht beispielsweise durch Anpassung des Brechungsindex erhöht werden. Derartige Funktionsschichten weisen vorzugsweise eine Dicke von weniger als 3 µm, insbesondere von weniger als 1 µm auf, um die Schichtdicke nicht unnötig zu vergrößern. Strukturierungen können vorzugsweise über Prägeverfahren oder durch Ätzen bewirkt werden. Auch Kombinationen verschiedener Schichten und/oder Strukturierungen stellen eine vorteilhafte Ausführung dar.

Als Haftkleber oder Heißschmelzkleber werden solche auf der Basis von Styrolblockcopolymeren, Polyisobutylen, Polyisobutylen-Blockcoploymeren oder Polyolefinen bevorzugt, da diese selbst über eine besonders hohe Permeationsbarriere verfügen. Solche Kleber sind beispielsweise in der DE 102008047964, DE 102008060113 oder der DE 102008062130 beschrieben.

Solche mit Kleberschichten ausgestattete Aufbauten werden bevorzugt als Klebeband in Form von Etiketten, Flächenmaterialien oder Rollen zur Verfügung gestellt und können mit den üblichen, aus dem Klebebandbereich bekannten Modifikationen, wie z.B. Abdeckungen, Release-Linern, Trennschichten oder Schutzschichten, versehen werden.

Die vorliegende Erfindung betrifft weiterhin ein Verfahren zur Herstellung der erfindungsgemäßen Barrierefolie, das folgende Schritte umfasst:
(a) Bereitstellen einer Polymerfolie,
(b) Beschichten der Polymerfolie mit einer anorganischen Barriereschicht zur Herstellung eines Verbundes,
(c) Beschichten des Verbundes mit einer zumindest teilweise organischen Ausgleichsschicht,
(d) Eindecken der zumindest teilweise organischen Ausgleichsschicht mit einem weiteren Verbund aus Polymerfolie und anorganischer Barriereschicht,
wobei die Polymerfolie in Schritt (a) oder der Verbund aus Polymerfolie und anorganischer Barriereschicht in Schritt (b) einem Hilfsträger mit einer wieder ablösbaren Klebemasse bereitgestellt wird.

Dieser Verbund kann z.B. durch Laminierung, aber auch durch andere dem Fachmann bekannte Verfahren wie z.B. Koextrusion oder Beschichtung hergestellt werden. Polymerfolie und Hilfsträger können dabei z.B. durch alle dem Fachmann bekannten Haftmechanismen, wie z.B. Kleben, elektrostatische Wechselwirkungen oder Autoadhäsion verbunden sein. Insbesondere können solche wieder ablösbaren Haftungen durch alle dem Fachmann bekannten Materialien und Verfahren hergestellt werden, insbesondere solchen aus dem Bereich des Wafer-Dicing oder Wafer-Grinding bekannten.

In einer Ausführung des Verfahrens wird also zunächst ein Hilfsträger mit einer wieder ablösbaren Klebemasse bereitgestellt, auf den die Polymerfolie laminiert wird. In einer zweiten Ausführung kann der Hilfsträger erst nach der Beschichtung der Polymerfolie mit der ersten anorganischen Barriereschicht aufgebracht werden. Auf diese jeweilige Basis werden im Folgenden die weiteren Schichten aufgebracht. Durch die Verwendung des Hilfsträgers wird die Herstellung des Aufbaus erleichtert, da der Hilfsträger auftretende mechanische und thermische Belastungen auffangen kann. Nach Abschluss des Verfahrens kann der Hilfsträger wieder entfernt werden. Dies kann unmittelbar nach der Fertigstellung der Folie erfolgen. Ein Entfernen der Folie ist jedoch auch erst (unmittelbar) vor oder nach Verwendung der Folie möglich, so dass der Hilfsträger des Weiteren als Oberflächenschutz während der Lagerung und des Transports dient.

In einer weiteren alternativen Ausführung kann auch die weitere Polymerschicht, wahlweise mit oder ohne weitere anorganische Barriereschicht, mit einem Hilfsträger ausgerüstet werden. Auch dieser Hilfsträger kann wahlweise direkt nach der Herstellung entfernt werden oder aber für Lagerung und Transport als Oberflächenschutz dienen.

Vorteilhafter Weise überschreitet die Bahnspannung während der Prozessschritte b) bis d) in einer Rolle-zu-Rolle-Fertigung den Wert von 25 MPa, insbesondere von 10 MPa, nicht, so dass ein Bahnriss vermieden wird.

Die Erfindung wird im Folgenden anhand der beigefügten Figuren näher beschrieben. Dabei zeigt/zeigen
Fig. 1 den schematischen Aufbau einer erfindungsgemäßen Permeationsbarrierefolie,
Fig. 2 den schematischen Aufbau eines erfindungsgemäßen Permeationsbarrierefolienverbundes,
Fig. 3 den schematischen Aufbau einer weiteren Ausführungsform der erfindungsgemäßen Permeationsbarrierefolie, und zwar in Verbindung mit einem Hilfsträger
Fig. 4 den schematischen Ablauf einer ersten Variante des erfindungsgemäßen Verfahrens,
Fig. 5A und 5B den schematischen Ablauf einer zweiten Variante des erfindungsgemäßen Verfahrens,
Fig. 6 den schematischen Aufbau einer erfindungsgemäßen Permeationsbarrierefolie mit einer Funktionsschicht,
Fig. 7 den schematischen Aufbau einer erfindungsgemäßen Permeationsbarrierefolie mit einer Kombination aus zwei Funktionsschichten,
Fig. 8 den schematischen Aufbau einer erfindungsgemäßen Permeationsbarrierefolie mit strukturierter Polymerschicht,
Fig. 9 den schematischen Aufbau einer erfindungsgemäßen Permeationsbarrierefolie mit einer weiteren Funktionsschicht und einer strukturierten Schicht, Fig. 10 den schematischen Aufbau einer erfindungsgemäßen Permeationsbarrierefolie mit strukturierter Polymerschicht in Kombination mit einer sehr dünnen Funktionsschicht,
Fig. 11 den schematischen Aufbau eines Klebebandes mit einer erfindungsgemäßen Permeationsbarrierefolie sowie einer Schicht Haftklebemasse, einem Release-Liner und einer reflektionsmindernden Funktionsschicht,
Fig. 12 den schematischen Aufbau einer erfindungsgemäßen Permeationsbarrierefolie mit strukturierter Polymerschicht in Kombination mit einer Funktionsschicht,
Fig. 13 den schematischen Aufbau einer erfindungsgemäßen Permeationsbarrierefolie mit innenliegenden Funktionsschichten und
Fig. 14 den schematischen Aufbau einer erfindungsgemäßen Permeationsbarrierefolie mit verschiedenen innenliegenden Funktionsschichten.

Es sei angemerkt, dass Positionsangaben wie "auf", "über", "oben", "darauf" oder "darüber" und dergleichen für die Anordnung der verschiedenen Schichten in der Folien bzw. dem Folienverbund nicht notwendiger Weise die absolute Position, sondern die Lage einer Schicht relativ zu einer anderen bezeichnen. Ferner sind die Figuren schematische Darstellungen von Folien. Dies gilt insbesondere im Hinblick auf die gezeigten Schichtdicken, die nicht maßstabsgetreu sind.

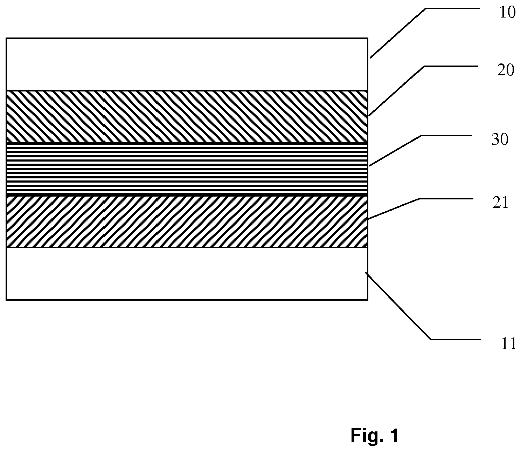

Wie in Fig. 1 gezeigt, besteht eine erfindungsgemäße transparente Permeationsbarrierefolie aus einer ersten Polymerschicht 10, auf der eine erste anorganische Barriereschicht 20 aufgebracht ist. Zum Ausgleich etwaiger Löcher und/oder Unebenheiten bzw. Rauhigkeiten in der anorganischen Barriereschicht ist auf der anorganischen Barriereschicht eine zumindest teilweise organische Ausgleichsschicht 30 aufgebracht. Auf diese Ausgleichsschicht folgen eine weitere anorganische Barriereschicht 21 sowie eine weitere organische Polymerschicht 11. Die anorganischen Barriereschichten 20, 21 können aus demselben Material oder aus unterschiedlichen Materialien bestehen. Entsprechendes gilt für die organischen Polymerschichten 10, 11. Wird dasselbe Material verwendet, ist die Verfahrensführung besonders einfach.

Die Schichtdicke der anorganischen Barriereschichten liegt jeweils zwischen 2 und 1.000 nm, vorzugsweise zwischen 10 und 500 nm, besonders bevorzugt zwischen 20 und 100 nm, die Schichtdicke der organischen Polymerschichten jeweils unterhalb von 5 µm, vorzugsweise zwischen 0,5 und 4 µm, besonders bevorzugt zwischen 1 und 2 µm. Auf diese Weise ist es möglich, sehr dünne Folien, d.h. Folien mit einer Dicke von nur wenigen µm bereit zu stellen, die trotzdem bereits eine relevante Permeationsbarriere für Sauerstoff und Wasserdampf bilden.

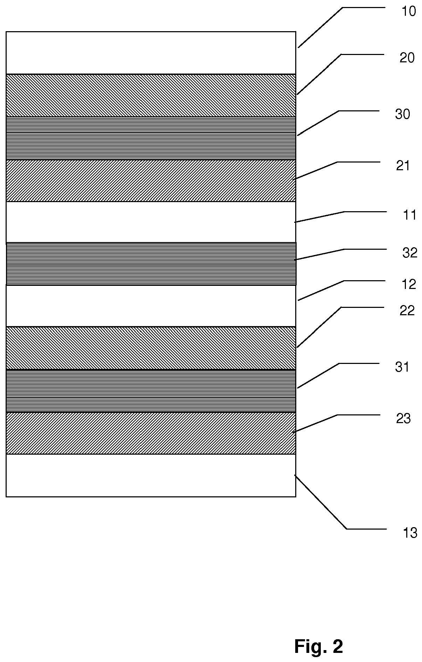

Um die Barriereeigenschaften weiter zu verbessern, können mehrere Folien, wie in Fig. 1 gezeigt, aufeinander laminiert werden. Fig. 2 zeigt einen Verbund, der durch das Aufeinanderlaminieren von zwei Folien, wie sie in Fig. 1 gezeigt sind, gebildet ist. Auf einer ersten Folie mit der Schichtfolge erste Polymerschicht 10 - erste anorganische Barriereschicht 20 - zumindest teilweise organische Ausgleichsschicht 30 - zweite anorganische Barriereschicht 21 - zweite Polymerschicht 11 ist mittels einer weiteren zumindest teilweise organischen Ausgleichsschicht 32 eine zweite Folie mit der Schichtfolge erste Polymerschicht 12 - erste anorganische Barriereschicht 22 - zumindest teilweise organische Ausgleichsschicht 31 - zweite anorganische Barriereschicht 23 - zweite Polymerschicht 13 auflaminiert. Abhängig von den verwendeten Materialien lassen sich mit einem solchen Aufbau problemlos Werte für WVTR und OTR im Bereich von 10⁻³ g/m²d bzw. cm³/m²d bar erreichen, und zwar bei Schichtdicken, die unterhalb von 20 µm liegen. Bei Folien nach dem Stand der Technik besteht das Problem, dass diese jeweils eine Substratbasis aufweisen, die bei Aufeinanderlaminieren mehrerer Folien entsprechend mehrfach im Verbund enthalten ist, so dass sich schnell große Werte für die Dicke des Verbundes ergeben, was beispielsweise für die Flexibilität Probleme aufwirft.

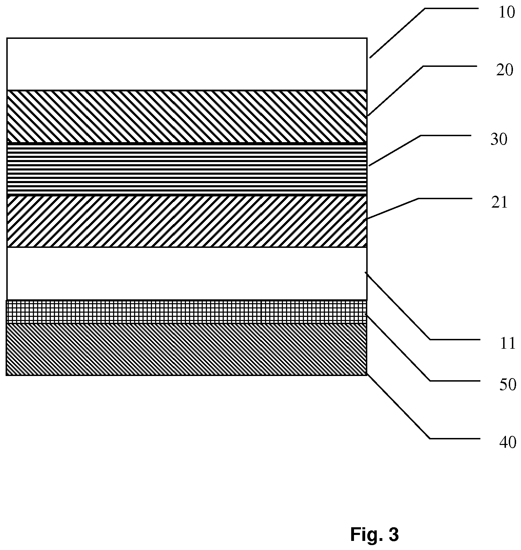

Eine weitere Ausführungsform ist in der Fig. 3 gezeigt. Die in Fig. 3 gezeigte Folie unterscheidet sich von der in Fig. 1 gezeigten Folie dadurch, dass die Folie mittels einer wieder ablösbaren Klebemasse 50 mit einem Hilfsträger 40 verbunden ist. Dieser Hilfsträger ist insbesondere bei der Herstellung der Folie von Vorteil, da er auftretende mechanische und thermische Belastungen auffangen kann. Aber auch für Lagerung und Transport der fertigen Folie ist er als Schutz der Folie hilfreich. Fig. 3 zeigt eine Folie, die auf einer Seite mit einem Hilfsträger versehen ist. Ebenso ist es möglich, dass der Hilfsträger auf beiden Seiten der Folie angebracht ist.

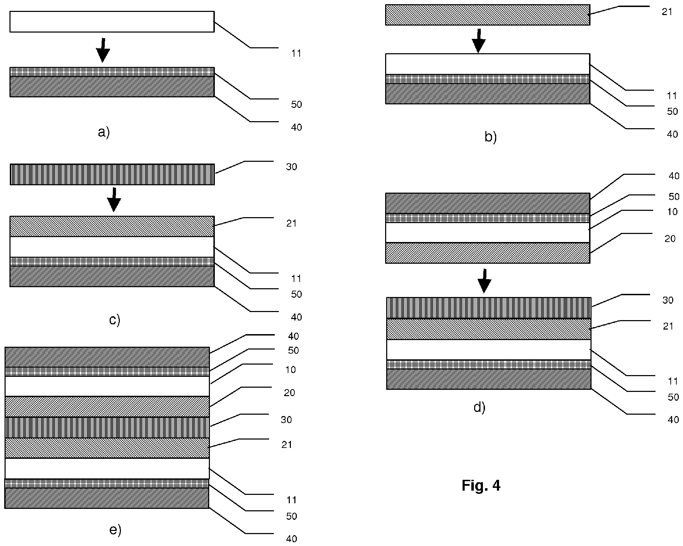

So zeigt Fig. 4 ein Verfahren zur Herstellung einer erfindungsgemäßen Folie, und zwar einer Folie, die auf beiden Seiten einen Hilfsträger aufweist. In Schritt a) ist gezeigt, wie auf den vorgelegten Hilfsträger 40, der mit einer wieder ablösbaren Klebemasse 50 versehen ist, zunächst eine Polymerschicht 11 aufgebracht wird. In einem zweiten Schritt, b), wird als nächstes eine anorganische Barriereschicht 21 aufgebracht. Schritt c) veranschaulicht die Aufbringung der zumindest teilweise organischen Ausgleichsschicht 30. In Schritt d) wird ein weiterer gemäß den Schritten a) und b) hergestellter Folienaufbau Hilfsträger 40 - wieder ablösbare Klebemasse 50 - Polymerschicht 10 - anorganische Barriereschicht 20 auf den in Schritt c) erhaltenen Folienaufbau laminiert, und zwar in der Weise, dass die anorganische Barriereschicht 20 auf die zumindest teilweise organische Ausgleichsschicht aufgebracht wird. Unter e) ist dann die fertige Folie gezeigt. Für den Fall, dass die anorganischen Barriereschichten 20, 21 und die Polymerschichten 10, 11 sowie Hilfsträger und ablösbare Klebemasse jeweils aus den gleichen Materialien bestehen, ergibt sich somit ein zur zumindest teilweise organischen Ausgleichsschicht spiegelsymmetrischer Aufbau der Folie.

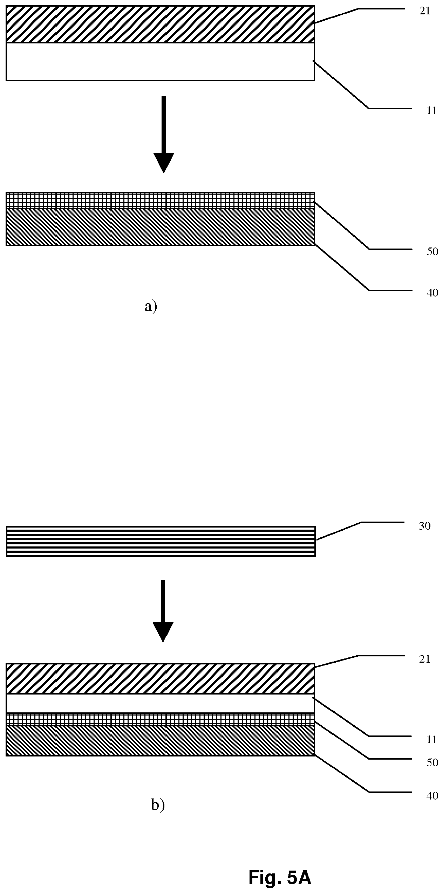

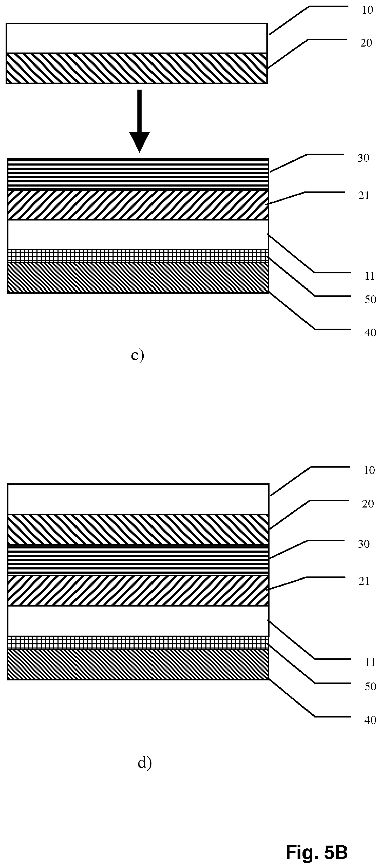

Fig. 5A und B zeigen eine alternative Verfahrensvariante, in der ein bereits vorgefertigter Verbund aus Polymerschicht 11 und anorganischer Barriereschicht 21 mit der Polymerschichtseite auf einen mit einer wieder ablösbaren Klebemasse 50 beschichteten Hilfsträger 40 aufgebracht wird (Schritt a)). In einem nächsten Schritt b) wird auf die anorganische Barriereschicht 21 die zumindest teilweise organische Ausgleichsschicht 30 aufgebracht. In Schritt c) wird auf diese Ausgleichsschicht 30 die anorganische Barriereseite eines weiteren vorgefertigten Verbundes aus anorganischer Barriereschicht 20 und Polymerschicht 10 gebracht, so dass eine Folie mit dem erfindungsgemäßen Aufbau erste Polymerschicht 10 - erste anorganische Barriereschicht 20 - zumindest teilweise organische Ausgleichsschicht 30 - zweite anorganische Barriereschicht 21 - zweite Polymerschicht 11 erhalten wird, bei der die Polymerschicht auf einer Seite über eine wieder ablösbare Klebemasse 50 mit einem Hilfsträger 40 verbunden ist.

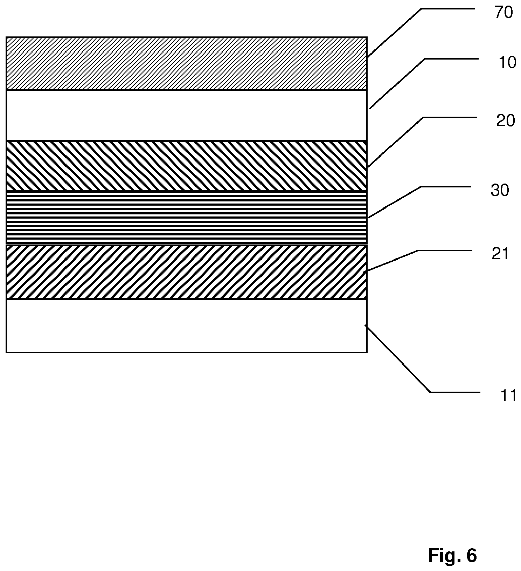

Die in Fig. 6 gezeigte Permeationsbarrierefolie entspricht in ihrem Aufbau der in Fig. 1 gezeigten. Zusätzlich weist sie auf einer Seite auf der ersten Polymerschicht 10 eine zusätzliche Funktionsschicht 70 auf. Hierbei kann es sich um eine elektrisch leitfähige Schicht, z.B. aus transparenten leitfähigen Oxiden wie ITO, um thermisch leitfähige Schichten, z.B. mit Aluminiumoxid oder Bornitrid angereicherte Schichten, oder um Kleberschichten, wie z.B. Haftkleber oder Heißschmelzkleber, handeln.

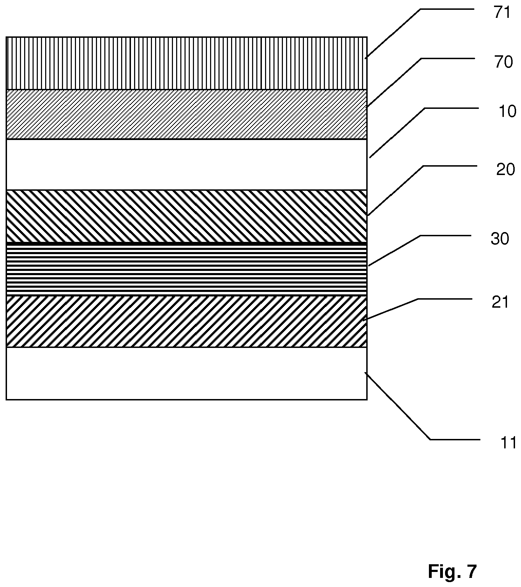

Zusätzlich zu dem in Fig. 6 gezeigten Aufbau enthält die in Fig. 7 gezeigte Barrierefolie neben der einen Funktionsschicht 70 noch eine zweite Funktionsschicht 71. Eine solche Folie kann somit an unterschiedliche Anforderungen angepasst werden.

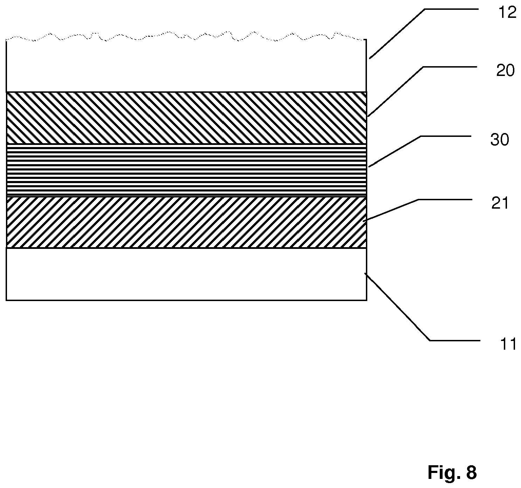

Fig. 8 zeigt eine Permeationsbarrierefolie entsprechend dem in Fig. 1 gezeigten Aufbau, wobei die erste Polymerschicht durch Strukturierung in eine strukturierte Polymerfolie 12 modifiziert wurde. Durch die Strukturierung können beispielsweise weitere Funktionsschichten besser aufgebracht bzw. besser auf der Schicht verankert werden.

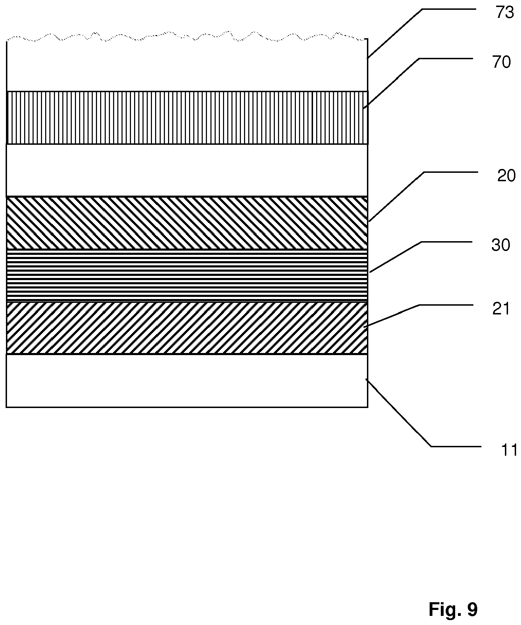

Zusätzlich zu der in Fig. 1 gezeigten Barrierefolie weist die in Fig. 9 gezeigte Folie eine weitere Funktionsschicht 70 auf der ersten Polymerschicht 10 auf. Auf der Funktionsschicht 70 befindet sich eine weitere Polymerschicht 73, die strukturiert ist.

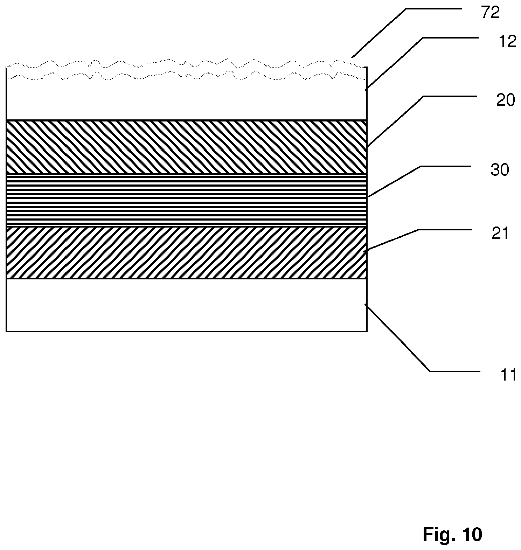

Fig. 10 zeigt eine Modifikation der in Fig. 8 gezeigten Barrierefolie. Die Folie der Fig. 10 weist zusätzlich zu derjenigen der Fig. 8 auf der strukturierten Polymerschicht 12 noch eine sehr dünne Funktionsschicht 72 auf.

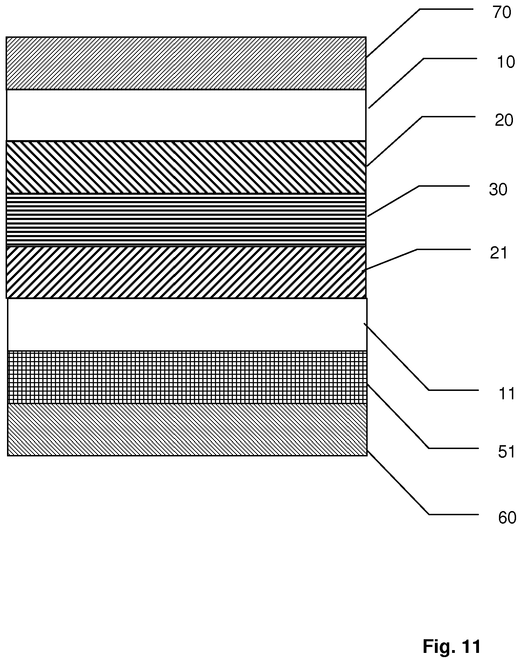

In Fig. 11 ist ein Klebeband gezeigt, das eine erfindungsgemäße Barrierefolie umfasst. Eine Barrierefolie, bestehend aus einer ersten Polymerschicht 10, einer ersten anorganischen Barriereschicht 20, einer zumindest teilweise organischen Ausgleichsschicht 30, einer weiteren anorganischen Barriereschicht 21 sowie einer weiteren organischen Polymerschicht 11 ist auf der ersten Polymerschicht 10 mit einer reflektionsvermindernden Funktionsschicht 70 versehen. Die zweite Polymerschicht 11 ist über eine Haftklebemasse 51 mit einem Release-Liner 60 als temporärem Träger verbunden. Dieser Träger bietet Schutz bei Transport und Lagerung der Barrierefolie.

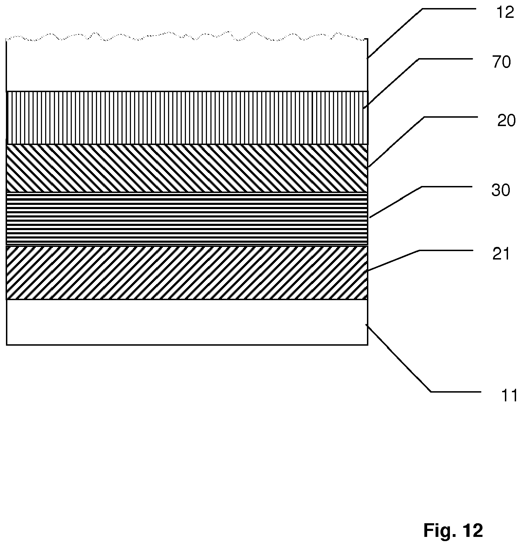

Eine Kombination einer erfindungsgemäßen Permeationsbarrierefolie mit strukturierter Polymerschicht (12) und Funktionsschicht (70) ist in Fig. 12 gezeigt. Bei dieser Folie ist die Funktionsschicht (70) zwischen erster anorganischer Barriereschicht (20) und der strukturierten Polymerschicht (12) angeordnet.

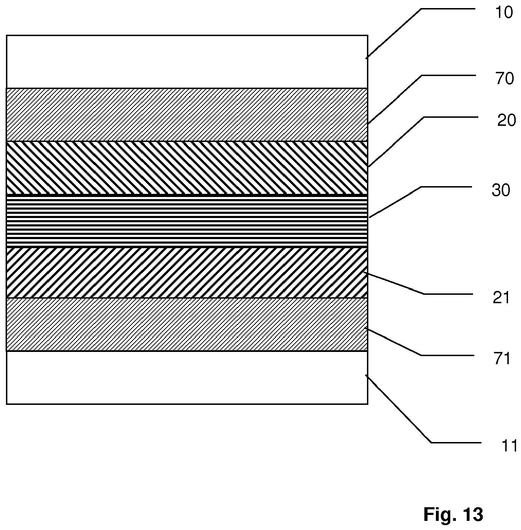

Noch eine weitere mögliche Anordnung ist der Fig. 13 zu entnehmen. In dieser weist die Permeationsbarrierefolie innen liegende Funktionsschichten 70, 71 auf. Diese können insbesondere als zumindest teilweise organische Ausgleichsschichten auf der polymeren Schicht aufgebracht sein, um eine glatte Oberfläche für die anorganische Barriereschicht bereitzustellen.

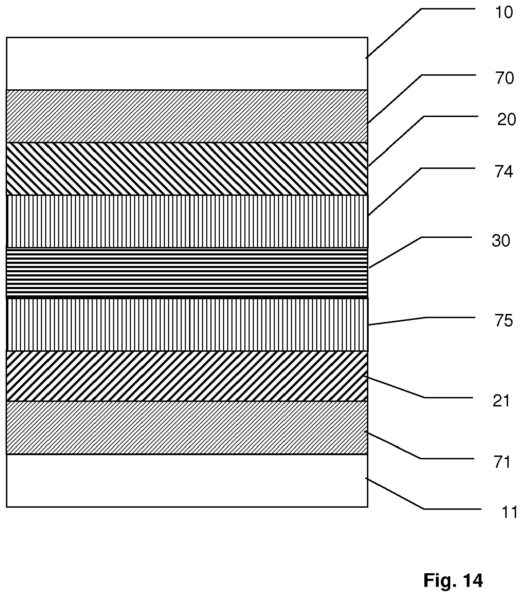

Fig. 14 zeigt eine Kombination, in der die erfindungsgemäße Permeationsbarrierefolie innen liegende Funktionsschichten 70, 71 sowie 74, 75 aufweist. Dabei sind die Funktionsschichten 70, 71 jeweils als organische Ausgleichsschicht auf der polymeren Schicht aufgebracht, um eine glatte Oberfläche für die anorganische Barriereschicht bereitzustellen. Die weiteren Funktionsschichten 74, 75 sind Schutzschichten, die die anorganischen Barriereschichten bei nachfolgenden Prozessen vor Beschädigungen schützen.

### Ausführungsbeispiele:

In den folgenden Ausführungsbeispielen kommen folgende Materialien zum Einsatz:
Folie 1:
   BOPP-Folie Kopafilm MET (Fa. Kopafilm, Nidda), 3,5 µm dick
   Die Folie wurde mit einer ca. 80 nm dicken SiOₓ-Barriereschicht versehen. Solche Beschichtungen führt z.B. das Fraunhoferinstitut für Elektronenstrahl- und Plasmatechnik (FhG-FEP) aus.
Folie 2:
   BOPET-Folie Hostaphan GN 4600 (Fa. Mitsubishi Plastics), 4 µm dick
Die Folie wurde mit einer ca. 80 nm dicken SiOx-Barriereschicht versehen. Solche Beschichtungen führt z.B. das Fraunhoferinstitut für Elektronenstrahl- und Plasmatechnik (FhG-FEP) aus.

### Laminierkleber:

Als Laminierkleber wurde folgende Rezeptur auf der Basis UV-vernetzender Harze verwendet:

| **Handelsname** | **Stoffname** | **Lieferant** | **[%]** |
|---|---|---|---|
| Genomer 4269/M22 | Urethanacrylat / Urethanmonomer | Rahn | 40 |
| IBOA | Isobornylacrylat | Cytec | 38 |
| Genomer 1122 | Urethanmonomer | Cytec | 15 |
| Irgacure 500 | Photoinitiator | Ciba | 4 |
| Ebecryl 7100 | N-Synergist | Cytec | 3 |
| | | **Summe:** | **100** |

Der Laminierkleber wies eine Viskosität von 200 mPas auf (Messung im Rotationsviskosimeter nach DIN 53019 bei 23°C)

Der Laminierkleber wurde mittels eines Rasterwalzenauftragswerks mit einer 140-er hexagonalen Rasterwalze im Gegenlauf (80%) beschichtet, wobei die Folie im Slip auf der Rasterwalze anlag, also nicht mittels eines Presseur angedrückt wurde, um die Kräfte auf die Folie gering zu halten. Die Bahnspannung betrug etwa 20 MPa.

Bei einer Bahngeschwindigkeit von 8 m/min ergab sich ein Masseauftrag von 2,5 g/m².

Die Gegenfolie wurde mit einem Presseur von einer Härte von 50 Shore auf den noch nicht ausgehärteten Laminierkleber auflaminiert.

### Beispiel 1:

Folie 1 wurde mit dem Laminierkleber beschichtet und dieser Verbund wiederum mit weiterer Folie 1 eingedeckt. Die Aushärtung erfolgte mit einer mit Mitteldruck-Quecksilberstrahlern bestückten UV-Anlage der Fa. IST mit einer Dosis von 40 mJ/cm².

### Beispiel 2

Folie 1 wurde mit dem Laminierkleber beschichtet und dieser Verbund wiederum mit weiterer Folie 1 eingedeckt. Die Aushärtung erfolgte mit einer mit Mitteldruck-Quecksilberstrahlern bestückten UV-Anlage der Fa. IST mit einer Dosis von 80 mJ/cm².

### Beispiel 3:

Folie 2 wurde mit der nicht mit der Barriereschicht versehenen Seite auf das reversible Klebeband tesa 50550 laminiert. Der Verbund wurde mit dem Laminierkleber beschichtet und mit Folie 2 eingedeckt.

### Beispiel 4:

Der Folienaufbau aus Beispiel 2 wurde mit dem Laminierkleber beschichtet und wiederum mit dem Folienaufbau aus Beispiel 2 eingedeckt. Die Aushärtung erfolgte mit einer mit Mitteldruck-Quecksilberstrahlern bestückten UV-Anlage der Fa. IST mit einer Dosis von 80 mJ/cm².

### Beispiel 5:

Der Folienaufbau aus Beispiel 4 wurde mit dem Laminierkleber beschichtet und wiederum mit dem Folienaufbau aus Beispiel 4 eingedeckt. Die Aushärtung erfolgte mit einer mit Mitteldruck-Quecksilberstrahlern bestückten UV-Anlage der Fa. IST mit einer Dosis von 80 mJ/cm².

### Vergleichsbeispiel 1:

Es wurde ein Vierfachlaminat einer 12 µ -PET-Folie mit SiOₓ-Beschichtung der Fa. Alcan Packaging getestet (Alcan UHBF).

Bei den so hergestellten Proben wurden Transmission und Haze nach ASTM D1003-00 ermittelt. WVTR und OTR wurden bei 38°C und 90% relativer Luftfeuchtigkeit nach STM F-1249 bzw. 23°C und 50% relativer Luftfeuchtigkeit nach DIN 53380-Teil3 gemessen. Die Ergebnisse sind in der nachstehenden Tabelle 2 zusammengefasst.

### Eigenschaften der Barrierefolien.

**Tabelle 2**

| Beispiel | Dicke [µm] | Transmission [%] | Haze [%] | WVTR [g/m² d] | OTR [cm³/m² d bar] |
|---|---|---|---|---|---|
| Folie 1 | 3,5 | 91 | 2,1 | 0,04 | 0,06 |
| Folie 2 | 4 | 90 | 2,3 | 0,06 | 0,02 |
| | | | | | |
| Beispiel 1 | 9 | 89 | 4,1 | 0,015 | 0,025 |
| Beispiel 2 | 11 | 88 | 4,0 | 0,02 | 0,01 |
| Beispiel 3 | 76 | - | - | - | - |
| Beispiel 4 | 20 | 86 | 5,9 | 0,009 | 0,006 |
| Beispiel 5 | 41 | 85 | 8,9 | 0,005 | 0,004 |
| | | | | | |
| Vergleichsbeispiel 1 | 50 | 88,23 | 5,8 | 0,08 | 0,028 |

Die Beispiele zeigen, dass der erfindungsgemäße Folienaufbau sehr gute Barrierewerte bei vergleichsweise geringer Foliendicke erreicht. So liegen WVTR und OTR für Folien mit einfachem Aufbau (Schichtdicke um 10 µm) bereits im Bereich von 10⁻² g/m² d bzw. cm³/m² d bar (vgl. Beispiele 1 und 2), diejenigen für einen Verbund mit verdoppeltem bzw. vervierfachten Aufbau (vgl. Beispiele 4 und 5) im Bereich von 10⁻³ g/m² d bzw. cm³/m² d bar.

## Patentansprüche

1. Transparente substratbasisfreie Permeationsbarrierefolie, bestehend aus einer ersten Polymerschicht (10), wobei die Polymerschicht (10) aus einer Folie besteht,
einer ersten anorganischen Barriereschicht (20),
zumindest einer zumindest teilweise organischen Ausgleichsschicht (30), wobei die Ausgleichsschicht (30) ein Laminierkleber ist, zumindest einer weiteren anorganischen Barriereschicht (21) sowie aus zumindest einer weiteren Polymerschicht (11), wobei die weitere Polymerschicht (11) aus einer Folie besteht,
wobei die Schichten in der angegebenen Reihenfolge übereinander angeordnet sind,
wobei sowohl die Polymerschichten wie auch die anorganischen Barriereschichten jeweils aus dem selben oder aus unterschiedlichem Material bestehen können, wobei die anorganischen Barriereschichten eine Dicke zwischen 2 und 1000 nm aufweisen und die Polymerschichten und die zumindest teilweise organische Ausgleichsschicht eine Dicke von weniger als 5 µm, vorzugsweise zwischen 0,5 und 4 µm, aufweisen.

2. Permeationsbarrierefolie nach Anspruch 1, **dadurch gekennzeichnet, dass** die Polymerschichten in zumindest einer Richtung, vorzugsweise in zwei Richtungen, orientiert vorliegen.

3. Permeationsbarrierefolie nach Anspruch 1 oder 2, **dadurch gekennzeichnet, dass** die Polymerschichten aus monoaxial oder biaxial verstreckten Folien bestehen.

4. Permeationsbarrierefolie nach Anspruch 3, **dadurch gekennzeichnet, dass** das Polymer ausgewählt ist aus der Gruppe bestehend aus Polyethylenterephthalat, Polyethylennaphthalat, Polybutylenterephthalat, Fluorpolyester, Polymethylpenten, Polynorbornen, substituierten Polyarylaten, Polyimid, Cyclo-Olefin-Copolymeren, Polysulfon, Polyphenylsulfon, Polyethersulfson und Polycarbonaten oder Copolymeren auf der Basis von Polymeren aus dieser Gruppe.

5. Permeationsbarrierefolie nach einem der Ansprüche 1 bis 4, **dadurch gekennzeichnet, dass** das Polymer einen Elastizitätsmodul (gemessen bei Raumtemperatur nach DIN EN ISO 527 (Probekörper Typ 2, 23°C, 50% relative Luftfeuchtigkeit, Abzugsgeschwindigkeit 1 mm/min)) von mehr als 2.000 MPa, vorzugsweise von mehr als 3.000 MPa, aufweist.

6. Permeationsbarrierefolie nach einem der Ansprüche 1 bis 5, **dadurch gekennzeichnet, dass** das Polymer einen Wassergehalt von weniger als 1 Gew.-% aufweist.

7. Permeationsbarrierefolie nach einem der Ansprüche 1 bis 6, **dadurch gekennzeichnet, dass** die anorganische Barriereschicht aus im Vakuum oder unter Atmosphärendruck abgeschiedenem Metall oder aus im Vakuum oder unter Atmosphärendruck abgeschiedenen Metallverbindungen, vorzugsweise aus Metalloxiden, Metallnitriden oder Metallhydronitriden, besteht.

8. Permeationsbarrierefolie nach Anspruch 7, **dadurch gekennzeichnet, dass** die anorganische Barriereschicht aus einer Verbindung, die aus der Gruppe bestehend aus Oxiden, Nitriden oder Hydronitriden des Siliziums, des Bors, des Aluminiums, des Zirkoniums, des Hafniums oder des Tellurs oder aus Indium-Zinn-Oxid ausgewählt ist, oder aus einer der vorgenannten Verbindungen, dotiert mit weiteren Elementen, besteht.

9. Permeationsbarrierefolienverbund, **dadurch gekennzeichnet, dass** der Verbund aus mindestens zwei Permeationsbarrierefolien nach einem der Ansprüche 1 bis 8 besteht, die durch zumindest eine weitere zumindest teilweise organische Ausgleichsschicht aufeinander laminiert werden, wobei die Permeationsbarrierefolien hinsichtlich ihrer Materialien und ihres Aufbaus übereinstimmen oder verschieden sein können.

10. Permeationsbarrierefolie nach einem der Ansprüche 1 bis 8 oder Permeationsbarrierefolienverbund nach Anspruch 9, **dadurch gekennzeichnet, dass** die Folie oder der Verbund für die Herstellung und/oder den Transport einen Hilfsträger (40), vorzugsweise beschichtet mit einer wieder ablösbaren Klebemasse (50), aufweist.

11. Permeationsbarrierefolie nach einem der Ansprüche 1 bis 8 oder Permeationsbarrierefolienverbund nach Anspruch 9 oder 10, **dadurch gekennzeichnet, dass** die Folie oder der Folienverbund auf zumindest einer Seite ganzflächig oder partiell mit mindestens einer weiteren funktionalen Schicht und/oder einer Strukturierung versehen sind, wobei die funktionelle Schicht insbesondere ausgewählt ist aus der Gruppe bestehend aus thermisch oder elektrisch leitfähigen Schichten, Schutzschichten, Kleberschichten, reflektionsvermindernden Schichten und/oder lichtaus- oder lichteinkoppelnden Schichten einschließlich Kombinationen solcher Schichten.

12. Permeationsbarrierefolie oder Permeationsbarrierefolienverbund nach Anspruch 11, **dadurch gekennzeichnet, dass** der Kleber der Kleberschicht ein Haftkleber oder ein Heißschmelzkleber ist, insbesondere ein Haft- oder ein Heißschmelzkleber auf Basis von Styrolblockcopolymeren, Polyisobutylen, Polyisobutylen-Blockcopolymeren oder Polyolefinen.

13. Permeationsbarrierefolie nach einem der Ansprüche 1 bis 8 oder 10 bis 12 oder Permeationsbarrierefolienverbund nach einem der Ansprüche 9 bis 12, **dadurch gekennzeichnet, dass** der Unterschied der Brechungsindizes von Polymerschicht, anorganischer Barriereschicht und zumindest teilweise organischer Ausgleichsschicht nicht mehr als 0,3, insbesondere nicht mehr als 0,1 beträgt.

14. Verfahren zur Herstellung einer Permeationsbarrierefolie nach einem der Ansprüche 1 bis 8 oder 10 bis 13, umfassend die folgenden Schritte:
a. Bereitstellen einer Polymerfolie (10),
b. Beschichten der Polymerfolie mit einer anorganischen Barriereschicht (20) zur Herstellung eines Verbundes,
c. Beschichten des Verbundes mit einer zumindest teilweise organischen Ausgleichsschicht (30), wobei die Ausgleichsschicht (30) ein Laminierkleber ist,
d. Eindecken der zumindest teilweise organischen Ausgleichsschicht mit einem weiteren Verbund aus Polymerfolie (11) und anorganischer Barriereschicht (21),
**dadurch gekennzeichnet, dass**
die Polymerfolie (10) in Schritt (a) oder der Verbund aus Polymerfolie (10) und anorganischer Barriereschicht (20) in Schritt (b) auf einem Hilfsträger (40) mit einer wieder ablösbaren Klebemasse bereitgestellt wird.

15. Verklebbares Flächengebilde umfassend eine Permeationsbarrierefolie nach einem der Ansprüche 1 bis 8 oder 10 bis 13 oder einen Permeationsbarrierefolienverbund nach einem der Ansprüche 9 bis 13.

## Claims

1. Transparent substrate-base-free permeation-barrier foil composed of a first polymer layer (10), wherein the polymer layer (10) is composed of a foil,
a first inorganic barrier layer (20),
at least one at least partially organic compensation layer (30), wherein the compensation layer (30) is a lamination adhesive, at least one further inorganic barrier layer (21), and also of at least one further polymer layer (11), wherein the further polymer layer (11) is composed of a foil,
wherein the layers are arranged one above the other in the stated sequence,
where not only the polymer layers but also the inorganic barrier layers can respectively be composed of the same, or of different, material, wherein the thickness of the inorganic barrier layers is from 2 to 1000 nm, and the thickness of the polymer layers and of the at least partially organic compensation layer is less than 5 µm, preferably from 0.5 to 4 µm.

2. Permeation-barrier foil according to Claim 1, **characterized in that** the polymer layers have orientation in at least one direction, preferably in two directions.

3. Permeation-barrier foil according to Claim 1 or 2, **characterized in that** the polymer layers are composed of monoaxially or biaxially oriented foils.

4. Permeation-barrier foil according to Claim 3, **characterized in that** the polymer has been selected from the group consisting of polyethylene terephthalate, polyethylene naphthalate, polybutylene terephthalate, fluoropolyester, polymethylpentene, polynorbornene, substituted polyarylates, polyimide, cycloolefin copolymers, polysulfone, polyphenyl sulfone, polyether sulfone and polycarbonates and copolymers based on polymers from this group.

5. Permeation-barrier foil according to any of Claims 1 to 4, **characterized in that** the modulus of elasticity (measured at room temperature to DIN EN ISO 527 (specimen type 2, 23°C, 50% relative humidity, separation velocity 1 mm/min)) of the polymer is more than 2000 MPa, preferably more than 3000 MPa.

6. Permeation-barrier foil according to any of Claims 1 to 5, **characterized in that** the water content of the polymer is less than 1% by weight.

7. Permeation-barrier foil according to any of Claims 1 to 6, **characterized in that** the inorganic barrier layer is composed of metal deposited in vacuo or metal deposited under atmospheric pressure or of metal compounds deposited in vacuo or metal compounds deposited under atmospheric pressure, preferably of metal oxides, metal nitrides, or metal hydronitrides.

8. Permeation-barrier foil according to Claim 7, **characterized in that** the inorganic barrier layer is composed of a compound selected from the group consisting of oxides, nitrides, or hydronitrides of silicon, of boron, of aluminium, of zirconium, of hafnium, or of tellurium, and of indium-tin oxide, or of one of the abovementioned compounds doped with further elements.

9. Permeation-barrier foil composite, **characterized in that** the composite is composed of at least two permeation-barrier foils according to any of Claims 1 to 8 which are laminated to one another via at least one further at least partially organic compensation layer, where the permeation-barrier foils can be identical or different in respect of their materials and their structure.

10. Permeation-barrier foil according to any of Claims 1 to 8, or permeation-barrier foil composite according to Claim 9, **characterized in that** the foil or the composite has, for the production process and/or for transport, a temporary carrier (40), preferably coated with a removable adhesive mass (50).

11. Permeation-barrier foil according to any of Claims 1 to 8, or permeation-barrier foil composite according to Claim 9 or 10, **characterized in that** all or part of at least one side of the foil or of the foil composite has at least one further functional layer, and/or a structuring, where the functional layer has in particular been selected from the group consisting of thermally or electrically conductive layers, protective layers, adhesive layers, antireflective layers, and/or light-output or light-input layers, inclusive of combinations of these layers.

12. Permeation-barrier foil or permeation-barrier foil composite according to Claim 11, **characterized in that** the adhesive of the adhesive layer is a pressure-sensitive adhesive or a hot-melt adhesive, in particular a pressure-sensitive or hot-melt adhesive based on styrene block copolymers, on polyisobutylene, on polyisobutylene block copolymers, or on polyolefins.

13. Permeation-barrier foil according to any of Claims 1 to 8 or 10 to 12, or permeation-barrier foil composite according to any of Claims 9 to 12, **characterized in that** the difference between the refractive indices of polymer layer, inorganic barrier layer, and at least partially organic compensation layer is not more than 0.3, in particular not more than 0.1.

14. Process for producing a permeation-barrier foil according to any of Claims 1 to 8 or 10 to 13, encompassing the following steps:
a. provision of a polymer foil (10),
b. coating of the polymer foil with an inorganic barrier layer (20) to produce a composite,
c. coating of the composite with an at least partially organic compensation layer (30), wherein the compensation layer (30) is a lamination adhesive,
d. covering the at least partially organic compensation layer with a further composite made of polymer foil (11) and inorganic barrier layer (21),
**characterized in that**
the polymer foil (10) in step (a), or the composite made of polymer foil (10) and inorganic barrier layer (20) in step (b), is provided on a temporary carrier (40) with an adhesive mass that can in turn be removed.

15. Adhesively bondable sheet encompassing a permeation-barrier foil according to any of Claims 1 to 8 or 10 to 13 or encompassing a permeation-barrier foil composite according to any of Claims 9 to 13.

## Revendications

1. Film barrière de perméation transparent sans base de substrat, constitué par une première couche polymère (10), la couche polymère (10) étant constituée par un film,
une première couche barrière inorganique (20),
au moins une couche d'égalisation au moins partiellement organique (30), la couche d'égalisation (30) étant un adhésif de stratification, au moins une autre couche barrière inorganique (21), ainsi qu'au moins une autre couche polymère (11), l'autre couche polymère (11) étant constituée par un film,
les couches étant agencées les unes sur les autres dans l'ordre indiqué,
aussi bien les couches polymères que les couches barrières inorganiques pouvant chacune être constituées du même matériau ou d'un matériau différent, les couches barrières inorganiques présentant une épaisseur comprise entre 2 et 1 000 nm, et les couches polymères et la couche d'égalisation au moins partiellement organique présentant une épaisseur de moins de 5 µm, de préférence comprise entre 0,5 et 4 µm.

2. Film barrière de perméation selon la revendication 1, **caractérisé en ce que** les couches polymères sont orientées dans au moins une direction, de préférence dans deux directions.

3. Film barrière de perméation selon la revendication 1 ou 2, **caractérisé en ce que** les couches polymères sont constituées de films étirés monoaxialement ou biaxialement.

4. Film barrière de perméation selon la revendication 3, **caractérisé en ce que** le polymère est choisi dans le groupe constitué par le polyéthylène téréphtalate, le polyéthylène naphtalate, le polybutylène téréphtalate, le fluoropolyester, le polyméthylpentène, le polynorbornène, les polyarylates substitués, le polyimide, les copolymères de cyclooléfine, la polysulfone, la polyphénylsulfone, la polyéthersulfone et les polycarbonates ou les copolymères à base de polymères de ce groupe.

5. Film barrière de perméation selon l'une quelconque des revendications 1 à 4, **caractérisé en ce que** le polymère présente un module d'élasticité (mesuré à température ambiante selon DIN EN ISO 527 (éprouvette de type 2, 23 °C, 50 % d'humidité relative de l'air, vitesse de retrait 1 mm/min)) de plus de 2 000 Mpa, de préférence de plus de 3 000 MPa.

6. Film barrière de perméation selon l'une quelconque des revendications 1 à 5, **caractérisé en ce que** le polymère présente une teneur en eau de moins de 1 % en poids.

7. Film barrière de perméation selon l'une quelconque des revendications 1 à 6, **caractérisé en ce que** la couche barrière inorganique est constituée par un métal déposé sous vide ou sous pression atmosphérique ou par des composés métalliques déposés sous vide ou sous pression atmosphérique, de préférence des oxydes de métaux, des nitrures de métaux ou des hydronitrures de métaux.

8. Film barrière de perméation selon la revendication 7, **caractérisé en ce que** la couche barrière inorganique est constituée par un composé qui est choisi dans le groupe constitué par les oxydes, les nitrures ou les hydronitrures de silicium, de bore, d'aluminium, de zirconium, d'hafnium ou de tellure, ou l'oxyde d'indium-étain, ou par un des composés susmentionnés, dopé avec d'autres éléments.

9. Composite de films barrières de perméation, **caractérisé en ce que** le composite est constitué par au moins deux films barrière de perméation selon l'une quelconque des revendications 1 à 8, qui sont stratifiés l'un sur l'autre par au moins une couche d'égalisation au moins partiellement organique, les films barrière de perméation pouvant être identiques ou différents au regard de leurs matériaux et de leur structure.

10. Film barrière de perméation selon l'une quelconque des revendications 1 à 8 ou composite de films barrières de perméation selon la revendication 9, **caractérisé en ce que** le film ou le composite comprend un support (40) pour la fabrication et/ou le transport, de préférence revêtu avec une masse adhésive décollable (50).

11. Film barrière de perméation selon l'une quelconque des revendications 1 à 8 ou composite de films barrières de perméation selon la revendication 9 ou 10, **caractérisé en ce que** le film ou le composite de films est muni sur au moins un côté sur l'ensemble de la surface ou en partie d'au moins une couche fonctionnelle supplémentaire et/ou d'une structuration, la couche fonctionnelle étant notamment choisie dans le groupe constitué par les couches thermiquement ou électriquement conductrices, les couches de protection, les couches adhésives, les couches réduisant les reflets et/ou les couches de couplage ou de découplage de lumière, y compris les combinaisons de telles couches.

12. Film barrière de perméation ou composite de films barrières de perméation selon la revendication 11, **caractérisé en ce que** l'adhésif de la couche adhésive est un adhésif de contact ou un adhésif thermofusible, notamment un adhésif de contact ou thermofusible à base de copolymères séquencés de styrène, de polyisobutylène, de copolymères séquencés de polyisobutylène ou de polyoléfines.

13. Film barrière de perméation selon l'une quelconque des revendications 1 à 8 ou 10 à 12 ou composite de films barrières de perméation selon l'une quelconque des revendications 9 à 12, **caractérisé en ce que** la différence entre l'indice de réfraction de la couche polymère, de la couche barrière inorganique et de la couche d'égalisation au moins partiellement organique n'est pas supérieure à 0,3, notamment pas supérieure à 0,1.

14. Procédé de fabrication d'un film barrière de perméation selon l'une quelconque des revendications 1 à 8 ou 10 à 13, comprenant les étapes suivantes :
a. la préparation d'un film polymère (10),
b. le revêtement du film polymère avec une couche barrière inorganique (20) pour la fabrication d'un composite,
c. le revêtement du composite avec une couche d'égalisation au moins partiellement organique (30), la couche d'égalisation (30) étant un adhésif de stratification,
d. le recouvrement de la couche d'égalisation au moins partiellement organique avec un autre composite du film polymère (11) et de la couche barrière inorganique (21),
**caractérisé en ce que**
le film polymère (10) à l'étape (a) ou le composite du film polymère (10) et de la couche barrière inorganique (20) à l'étape (b) est préparé sur un support (40) avec une masse adhésive décollable.

15. Structure plate collable comprenant un film barrière de perméation selon l'une quelconque des revendications 1 à 8 ou 10 à 13 ou un composite de films barrières de perméation selon l'une quelconque des revendications 9 à 13.
